# EUROPÄISCHE PATENTSCHRIFT

(11) **EP 2 699 066 B1**
(45) Veröffentlichungstag und Bekanntmachung des Hinweises auf die Patenterteilung: **20.05.2015**
(21) Anmeldenummer: 12180455.3
(22) Anmeldetag: 14.08.2012
(51) Int. Cl.: H05K 5/02, H05K 7/18

(54) **Verriegelungselement zur Verriegelung eines Deckblechs an einer Modulschiene**
Locking element for locking a cover plate to a module rail
Élément de verrouillage destiné à verrouiller une coiffe sur un rail de module

(43) Veröffentlichungstag der Anmeldung: 19.02.2014
(73) Patentinhaber: Pentair Technical Solutions GmbH, 75334 Straubenhardt (DE)
(72) Erfinder: Joist, Michael, 76571 Gaggenau (DE)
(74) Vertreter: Durm & Partner

(56) Entgegenhaltungen:
- EP-A2- 1 001 669
- JP-A- 2002 217 572
- JP-A- 2004 251 055
- US-A1- 2012 019 116

## Beschreibung

Die Erfindung betrifft ein Verriegelungselement zur Verriegelung eines Deckblechs an einer Modulschiene.

Bei 19-Zoll-Aufbausystemen werden Deckbleche zur Verkleidung von Gehäuseteilen, insbesondere Baugruppenträgern, verwendet. Ein solches Gehäuse weist zwei vertikale Seitenwände auf, die an ihrer Ober- und Unterseite über je zwei horizontale Modulschienen miteinander verbunden sind. An diesen Modulschienen können Führungsschienen vorgesehen sein, in die Leiterplatten mit elektronischen Bauelementen eingeschoben werden.

Die Befestigung der Deckbleche am Gehäuse erfolgt üblicherweise durch Eingriff in die Modulschienen und Verbindung mit den Seitenwänden. Hierzu sind die Deckbleche an ihren Rändern abgekantet. Die Abkantungen an den den Modulschienen zugewandten Seiten greifen in Nuten in den Modulschienen ein. In diesen Nuten können EMV-Dichtungen, wie beispielsweise Kontaktierungsfedern, vorgesehen sein, um die Umgebung von elektromagnetischer Strahlung der eingebauten Elektronikkomponenten abzuschirmen. An den den Seitenwänden zugewandten Seiten der Deckbleche sind die Abkantungen mit Bohrlöchern durchsetzt, durch welche die Deckbleche mit den Seitenwände des Baugruppenträgers verschraubt werden.

Sollen 19-Zoll-Aufbausysteme erhöhten Belastungen wie beispielsweise hohen statischen oder dynamischen Lasten standhalten, müssen nicht nur die Profile der Modulschienen an die höheren Anforderungen angepasst werden. Auch die Befestigung der Deckbleche muss konstruktiv auf die erhöhte Belastung abgestimmt sein. Insbesondere bei großen Gehäusebreiten und hohen Schock- und Vibrationsbelastungen reicht für eine sichere Verbindung zwischen Deckblech und Modulschiene ein Einstecken des abgekanteten Deckblechs in eine Nut der Modulschiene nicht mehr aus. Hohe Belastungen im Betrieb könnten dazu führen, dass das Deckblech aus der Nut der Modulschiene herausrutscht. Eine sichere Verbindung zwischen Deckblech und Gehäuse und damit eine EMV-Abschirmung gegenüber der Umgebung wären dann nicht mehr gegeben.

JP-A-2004-251055 offenbart eine federbelastete Schiebeverriegelungsvorrichtung, die dem Oberbegriff von Anspruch 1 entspricht.

Angesichts der beschriebenen Problematik ist es Aufgabe der vorliegenden Erfindung, ein Verriegelungselement bereitzustellen, das auch bei hohen Belastungen eine sichere Befestigung eines Deckblechs an einer Modulschiene gewährleistet, wobei diese Befestigung ohne Demontage von Bauteilen oder Entfernung von Steckbaugruppen leicht lösbar sein soll, um bei Bedarf das Deckblech abzunehmen.

Gelöst wird die vorliegende Aufgabe durch ein Verriegelungselement zur Befestigung eines Deckblechs an einer Modulschiene mit den Merkmalen des Anspruchs 1.

Das erfindungsgemäße Verriegelungselement umfasst einen Lageblock mit einer im Wesentlichen ebenen Montagefläche und Befestigungsmitteln zur Montage an der Innenseite des Deckblechs. Die Montagefläche bildet eine Anlagefläche zur Anlage des Lagerblocks an dem Deckblech. Hierdurch wird eine einfache Befestigung des Lagerblocks mit Hilfe von Befestigungsmittel an der Innenseite des Deckblechs ermöglicht.

Das Verriegelungselement umfasst weiter einen Schieberiegel, der auf dem Lagerblock verschieblich gelagert ist und eine Verriegelungszunge aufweist. Der Schieberiegel ist vorzugsweise parallel zum Lagerblock und in Längsrichtung desselben verschiebbar. Somit können unterschiedliche Positionen des Schieberiegels relativ zu dem Lagerblock realisiert werden.

Es ist ferner ein Schiebegetriebe vorgesehen, das den Schieberiegel von einer Verriegelungsposition in eine Freigabeposition bzw. umgekehrt verschiebt. In der Verriegelungsposition untergreift die Verriegelungszunge die Modulschiene. Damit wird ein Abheben des Deckblechs von der Modulschiene unmöglich.

Der Antrieb des Schiebegetriebes erfolgt über einen Drehantrieb, der bei montiertem Verriegelungselement durch ein Loch im Deckblech betätigbar ist. Folglich ist der Drehantrieb des Schiebegetriebes von der Außenseite des Deckblechs leicht zugänglich, wodurch eine Betätigung des Schieberiegels ermöglicht wird, ohne andere Bauteile zu demontieren und insbesondere ohne elektronische Baugruppen aus dem Gehäuse zu entfernen. Der Schieberiegel kann allein durch Eingriff von der Außenseite des Deckblechs her in die Freigabeposition überführt werden, so dass ein Abnehmen des Deckblechs sehr leicht und einfach erfolgen kann. Umgekehrt lässt sich das Deckblech auch wieder einfach aufsetzen und mittels des Schieberiegels gegen die Modulschiene verriegeln.

Vorzugsweise sind in der Montagefläche des Lagerblocks Gewindelöcher für Befestigungsschrauben vorgesehen. Die Befestigungsschrauben können durch Löcher im Deckblech hindurch in die Gewindelöcher der Montagefläche eingeschraubt werden. Die Gewindelöcher können vorteilhaft Senkungen aufweisen, so dass die Befestigungsschrauben beim Einschrauben in die Gewindelöcher das Deckblech derart verformen, dass die Schraubenköpfe der Befestigungsschrauben bündig mit der Außenfläche des Deckblechs abschließen.

Ein weiteres optionales Merkmal der Erfindung ist, dass der Drehantrieb eine Betätigungsschraube umfasst, die in dem Lagerblock um eine Drehachse senkrecht zur Montagefläche drehbar gelagert ist und den Schieberiegel durchsetzt. Es ist eine Schiebemutter vorgesehen, die auf das untere Ende der Betätigungsschraube aufgeschraubt ist und in den Schieberiegel eingreift. Eine schräge Gleitfläche ist am Schieberiegel angeordnet, auf der die Schiebemutter derart gleitet, dass ein Anziehen der Betätigungsschraube gegen die Schiebemutter eine Verschiebung des Schieberiegels quer zur Drehachse der Betätigungsschraube bewirkt.

Vorteilhaft ist der Schieberiegel auf der der Montagefläche abgewandten Seite des Lagerblocks angeordnet. Die Betätigungsschraube ragt, ausgehend von der Montagefläche des Lagerblocks, durch den Lagerblock und den darauf angeordneten Schieberiegel hindurch. Auf das freie Ende der Betätigungsschraube ist eine Schiebemutter aufgeschraubt, so dass der Schieberiegel zwischen Schiebemutter und Lagerblock gehalten wird. Durch Anziehen der Betätigungsschraube verringert sich der Abstand zwischen Schiebemutter und Lagerblock und die Schiebemutter gleitet auf der schrägen Gleitfläche des Schieberiegels ab. Dabei vollführt die Schiebemutter eine translatorische Bewegung entlang der Achse der Betätigungsschraube. Mittels der Gleitfläche am Schieberiegel wird die translatorische Bewegung der Schiebemutter in eine quer dazu ausgerichtete translatorische Bewegung des Schieberiegels umgesetzt.

Die Schiebemutter weist vorteilhaft zwei Keilflächen auf, die in einem schrägen Winkel zur Drehachse der Betätigungsschraube verlaufen. Beispielsweise sind die Keilflächen in einem Winkel zwischen 30° und 60°, bevorzugt in einem Winkel zwischen 40° und 50°, insbesondere zwischen 43° und 47° angeordnet. Der Schieberiegel weist zwei zu den Keilflächen korrespondierende Gleitflächen auf, die parallel zu den Keilflächen verlaufen und auf den die Keilflächen gleiten. Dadurch wird beim Anziehen der Betätigungsschraube der Schieberiegel in die eine und beim Lösen der Betätigungsschraube in die entgegengesetzte andere Richtung quer zur Drehachse der Betätigungsschraube gedrückt, um den Schieberiegel in die Freigabeposition bzw. Verriegelungsposition zu verschieben. Bevorzugt befinden sich sowohl die Keilflächen wie auch die Gleitflächen in Verfahrrichtung des Schieberiegels auf jeweils einander gegenüberliegenden Seiten der Schiebemutter bzw. des Schieberiegels. Die Keilflächen bzw. Gleitflächen stellen eine konstruktiv einfache Möglichkeit dar, um eine lineare Bewegung der Schiebemutter entlang der Drehachse der Betätigungsschraube in eine hierzu quer verlaufende Bewegung des Schieberiegels umzusetzen.

In vorteilhafter Weiterbildung der Erfindung ist der Schieberiegel durch die vollständig angezogene Betätigungsschraube in der Verriegelungsposition arretiert. Ein unkontrolliertes Verschieben des Schieberiegels wird damit verhindert, wodurch eine sichere Befestigung des Deckblechs an der Modulschiene gewährleistet ist. Vorzugsweise wird der Schieberiegel zwischen Lagerblock und Schiebemutter festgeklemmt.

Es ist zweckmäßig, dass der Kopf der Betätigungsschraube bündig mit der Montagefläche des Lagerblocks abschließt. Dadurch entsteht eine plane Montagefläche, die eine einfache Montage des Lagerblocks an dem Deckblech ermöglicht.

Ein weiteres optionales Merkmal der Erfindung ist, dass der Kopf der Betätigungsschraube einen Antrieb für einen Schraubendreher hat. Folglich ist die Betätigungsschraube bequem mittels eines handelsüblichen Schraubendrehers betätigbar. Ein schnelles und einfaches Anziehen bzw. Lösen der Betätigungsschraube ist somit gewährleistet. Der Kopf weist beispielsweise eine Aufnahme für einen Innensechskant ("Inbus") oder einen Innensechsrund ("Torx") auf. Es sind aber auch andere Aufnahmen für Schraubendreher mit gängigen Schrauben-Mitnahmeprofilen denkbar.

An dem Schieberiegel ist vorteilhaft ein Anschlag vorgesehen, der gegen die Betätigungsschraube fährt, bevor diese ganz aus der Schiebemutter herausgedreht ist. Über den Anschlag kann der Verfahrweg des Schieberiegels relativ zu dem Lagerblock begrenzt werden. Bevorzugt schlägt der Anschlag in der Freigabeposition an der Betätigungsschraube an. Im montierten Zustand des Verriegelungselements stützt sich der Kopf der Betätigungsschraube am Deckblech ab, so dass die Schiebemutter auf der Betätigungsschraube nach unten wandert. Indem der Anschlag den Verfahrweg des Schieberiegels begrenzt, bevor die Betätigungsschraube vollständig aus der Schiebemutter herausgedreht ist, wird gewährleistet, dass sich die Betätigungsschraube oder die Schiebemutter nicht unkontrolliert von der Schiebemutter lösen kann. Auch der Schieberiegel ist dadurch an dem Lagerblock unverlierbar fixiert. Wird das Verriegelungselement zum Befestigen eines Deckblechs an einem Gehäuse verwendet, ist gewährleistet, dass kein Bauteil des Verriegelungselementes in das Innere des Gehäuses fallen kann, unabhängig davon, ob das Deckblech verriegelt ist oder gerade abgenommen wird.

Es ist zweckmäßig, dass die Betätigungsschraube in einem Langloch des Schieberiegels sitzt. Somit ist ein Verschieben des Schieberiegels relativ zu der Betätigungsschraube und quer zu deren Achse möglich.

Teil der vorliegenden Erfindung ist auch ein Gehäuse zur Aufnahme elektronischer Komponenten, umfassend vordere und hintere Modulschienen und wenigstens ein Deckblech mit im Raster angeordneten Löchern und mit einer Abkantung, die in eine Nut einer Modulschiene eingreift. An der Innenseite des Deckblechs ist wenigstens ein Verriegelungselement der vorstehend beschriebenen Art derart befestigt, dass die Verriegelungszunge in Verriegelungsposition die Modulschiene untergreift. Beispielsweise ist das Gehäuse als Baugruppenträger ausgebildet, der zwei Seitenwände aufweist, die über horizontale Modulschienen miteinander verbunden sind. Das Deckblech ist mit den Seitenwänden verschraubt und zusätzlich über mindestens ein Verriegelungselement an der Modulschiene befestigt. Ein Abheben des Deckblechs von der Modulschiene wird somit verhindert.

Bei einer Weiterbildung des erfindungsgemäßen Gehäuses sind die Gewindelöcher in der Montagefläche des Lagerblocks entsprechend dem Raster der Löcher im Deckblech angeordnet. Folglich müssen keine zusätzlichen Löcher zur Befestigung des Verriegelungselements an dem Deckblech vorgesehen werden. Eine Montage des Verriegelungselements an einem bestehenden Deckblech ist somit schnell und einfach möglich.

Ist die Drehachse der Betätigungsschraube konzentrisch zu einem Loch des Deckblechs, ist es möglich die Betätigungsschraube durch das Deckblech hindurch mittels eines Werkzeugs wie beispielsweise einem Schraubendreher zu betätigen. Das Verriegelungselement kann somit einfach von der Außenseite des Gehäuses durch das Deckblech hindurch betätigt werden. Beispielsweise kann der Schieberiegel von der Außenseite des Gehäuses aus in die Freigabeposition überführt werden. Somit kann das Deckblech ohne vorherige Demontage von Elektronikkomponenten wieder von dem Gehäuse gelöst werden.

Die Betätigungsschraube muss sich gut gegen die Innenseite des Deckblechs abstützen, wenn der Kopf der Betätigungsschraube einen größeren Durchmesser hat als das korrespondierende Loch im Deckblech. Wird die Betätigungsschraube gelöst, drückt sie sich zunächst gegen die aufgeschraubte Schiebemutter nach oben, bis der Kopf der Betätigungsschraube an das Deckblech anstößt. Ein weiteres Lösen der Betätigungsschraube bewirkt dann ausschließlich eine Bewegung der Schiebemutter nach unten von dem Lagerblock weg. Befindet sich der Schieberiegel beispielsweise in der Freigabeposition, d.h. schlägt der Anschlag des Schieberiegels an die Betätigungsschraube an, ist die Schiebemutter arretiert. Zum einen kann die Schiebemutter aufgrund des Anschlags den Schieberiegel nicht weiter verschieben, zum anderen wird sie von der Betätigungsschraube, deren Kopf sich am Deckblech abstützt, weiter gegen den Schieberiegel gedrückt. Aufgrund der Arretierung der Schiebemutter ist auch gewährleistet, dass im montierten Zustand des Verriegelungselements ein Trennen der Betätigungsschraube von der Schiebemutter nicht möglich ist. Somit kann keine Komponente des Verriegelungselements unkontrolliert in das Innere des Gehäuses gelangen.

An der Montagefläche des Lagerblocks sind vorteilhaft Positionierpins ausgebildet, welche in korrespondierende Löcher des Deckblechs eingreifen. Das Verriegelungselement kann so schnell und einfach relativ zum Deckblech positioniert und exakt ausgerichtet werden. Dies gewährleistet automatisch eine Montage des Verriegelungselements in korrekter Position. Vorzugsweise sind die Positionierpins derart an der Montagefläche angeordnet, dass im eingebauten Zustand des Verriegelungselements zwangsweise eine Positionierung der Gewindelöcher konzentrisch zu vorhandenen Löchern im Deckblech erfolgt.

Ein Ausführungsbeispiel der Erfindung wird nachstehend anhand der beigefügten Zeichnungen beschrieben. Es zeigen:
- Figur 1: eine perspektivische Ansicht eines Gehäuses;
- Figur 2: einen Blick auf die Innenseite des Deckblechs des Gehäuses von Fig. 1 mit zwei montierten Verriegelungselementen in größerem Maßstab;
- Figur 3a: einen Vertikalschnitt entlang der Linie A-A in Figur 2;
- Figur 3b: einen Vertikalschnitt entlang der Linie B-B in Figur 2;
- Figur 4: eine perspektivische Explosionszeichnung eines Verriegelungselements von Fig. 2.

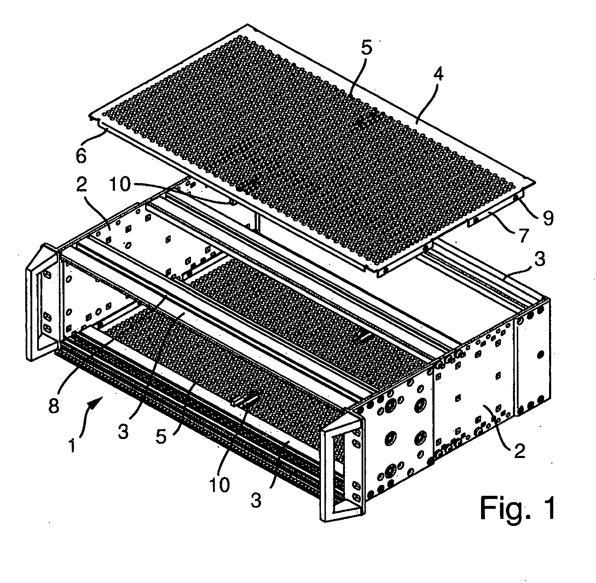

Figur 1 zeigt ein leeres Gehäuse 1, das zur Aufnahme von elektrischen Steckbaugruppen vorgesehen ist. Das Gehäuse 1 umfasst zwei Seitenwände 2, die über obere und untere Modulschienen 3 miteinander verbunden sind. Es sind Deckbleche 4 vorgesehen, die im Raster angeordnete Löcher 5 aufweisen. Die Löcher 5 durchdringen die Deckbleche 4 vollständig. Die Deckbleche 4 weisen erste Abkantungen 6 entlang ihrer langen Seite und zweite Abkantungen 7 entlang ihrer kurzen Seite auf. Während die ersten Abkantungen 6 in Nuten 8 der Modulschienen 3 eingreifen, sind entlang der zweiten Abkantungen 7 Bohrungen 9 vorgesehen, über die das Deckblech 4 mit den Seitenwänden 2 mit Hilfe von Schrauben verbunden wird. An den Innenseiten der Deckbleche 4 sind beispielhaft insgesamt vier Verriegelungselemente 10 vorgesehen.

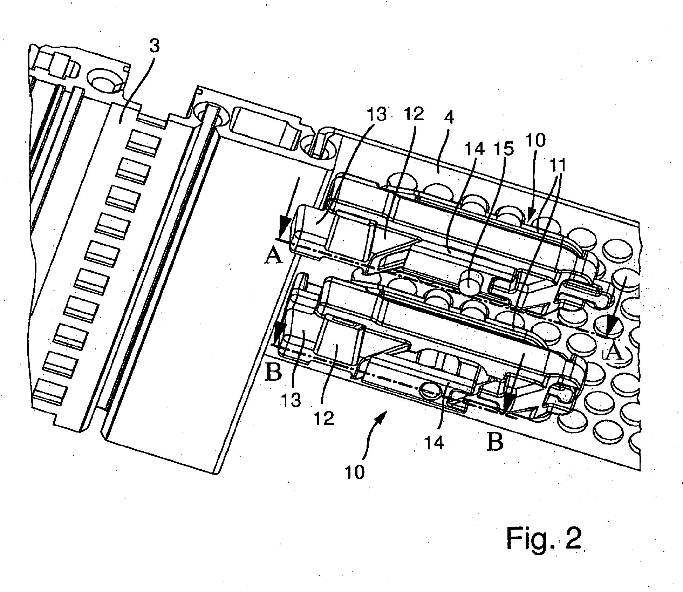

Figur 2 zeigt einen Ausschnitt der Unterseite des in Figur 1 dargestellten oberen Deckblechs 4. Es sind hier - entgegen Figur 1 - zwei Verriegelungselemente 10 eng nebeneinander zu sehen, was in der Praxis so nicht vorkommen wird.

Jedes Verriegelungselement 10 weist einen Lagerblock 11 auf, der an dem Deckblech 4 befestigt ist. Jedes Verriegelungselement 10 umfasst einen Schieberiegel 12, der relativ zu dem Lagerblock 11 in Längsrichtung verschiebbar ist und an seiner der Modulschiene 3 zugewandten Seite eine Verriegelungszunge 13 aufweist. Teil eines Verriegelungselements 10 ist weiter eine Schiebemutter 14, die auf das Ende einer Betätigungsschraube 15 aufgeschraubt ist. Die Betätigungsschraube 15 und die Schiebemutter 14 wirken zusammen mit dem Schieberiegel 12 als ein Schiebegetriebe, das den Schieberiegel 12 relativ zu dem Lagerblock 11 verschiebt. Die Betätigungsschraube 15 dient dabei als Drehantrieb des Schiebegetriebes.

Das in Figur 2 rechte Verriegelungselement 10 befindet sich in Verriegelungsposition, in der die Verriegelungszunge 13 die Modulschiene 3 untergreift. Das linke Verriegelungselement 10 ist dagegen in einer Freigabeposition. Im Vergleich zur Verriegelungsposition ist der Schieberiegel 12 in der Freigabeposition relativ zu dem Lagerblock 11 derart verschoben, dass die Verriegelungszunge 13 nicht mehr die Modulschiene 3 untergreift. Hierzu wurde der Schieberiegel 12 von der Modulschiene 3 weg nach hinten verschoben. In der Freigabeposition ist also die Verriegelungszunge 13 von der Modulschiene 3 beabstandet angeordnet, so dass die Modulschiene 3 nicht berührt wird. Befinden sich alle an dem Deckblech 4 montierten Verriegelungselemente 10 in der Freigabeposition und sind darüber hinaus die Verbindungen zu den Seitenwänden 2 gelöst, kann das Deckblech 4 von der Modulschiene 3 abgenommen werden.

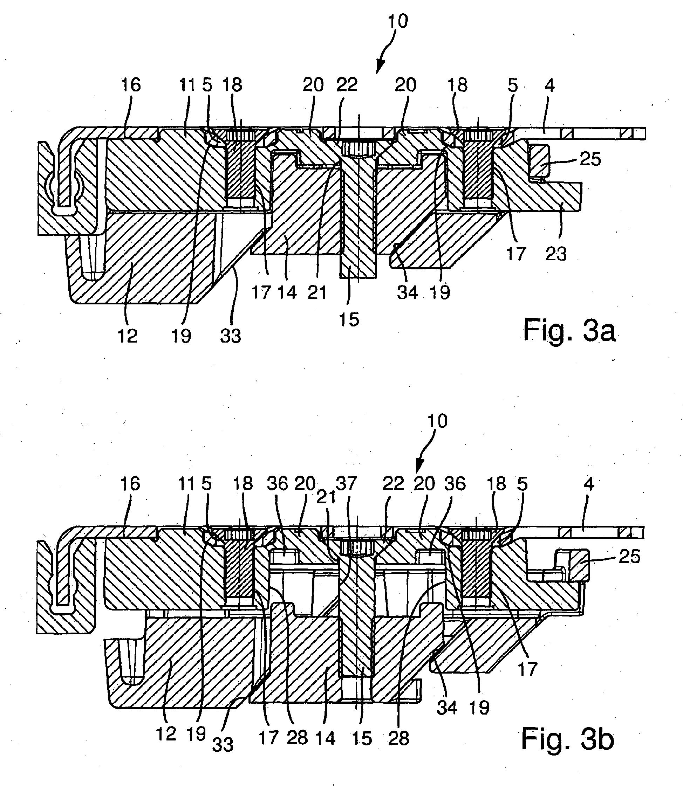

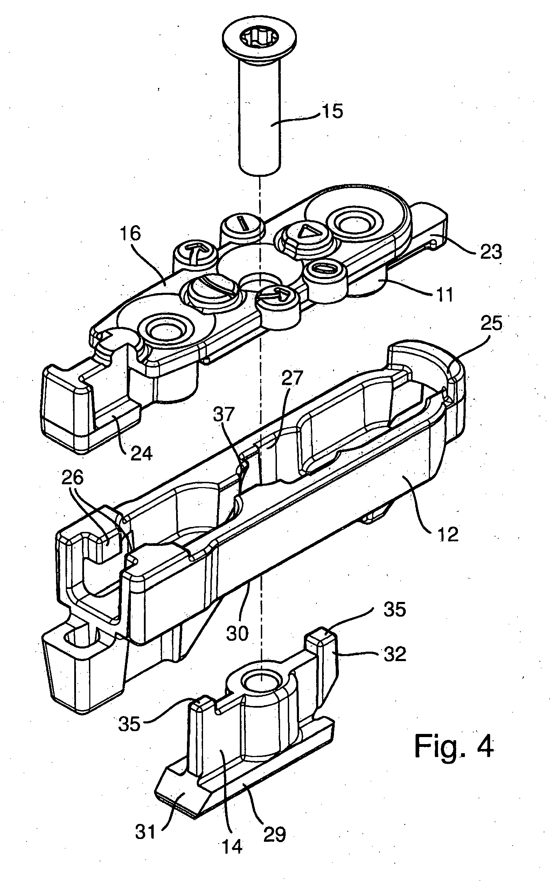

Die Details des Verriegelungselements 10 und dessen Funktion sollen nun anhand der Figuren 3a, 3b und 4 näher erläutert werden.

Der Lagerblock 11 des Verriegelungselements 10 hat eine Montagefläche 16, an der das Verriegelungselement 10 mit dem Deckblech 4 verbunden ist. Die Montagefläche 16 ist im Wesentlichen eben ausgebildet und kommt an der Innenseite des Deckblechs 4 zur Anlage. Sie weist Gewindelöcher 17 auf, in die Befestigungsschrauben 18, die durch die Löcher 5 im Deckblech 4 ragen, eingeschraubt sind. Die Befestigungsschrauben 18 sind hier Senkkopfschrauben mit Innensechskant. Die Gewindelöcher 17 sind dem Raster der Löcher 5 entsprechend angeordnet. Die Gewindelöcher 17 weisen Senkungen 19 auf. Werden die Befestigungsschrauben 18 durch die Löcher 5 hindurch in die Gewindelöcher 17 eingeschraubt, verformen die Befestigungsschrauben 18 das Deckblech 4 derart, dass es sich in die Senkungen der Gewindelöcher 17 legt. Somit sind die Köpfe der Befestigungsschrauben 18 im Deckblech 4 versenkt und stehen nicht über die obere Fläche des Deckblechs 4 hinaus.

Auf der Montagefläche 16 sind ferner Positionierpins 20 angeordnet, die einen kreisrunden Querschnitt aufweisen. Der Außendurchmesser der Positionierpins 20 entspricht in etwa dem Durchmesser der Löcher 5 im Deckblech 4. Die Positionierpins 20 können somit in die Löcher 5 des Deckblechs 4 eingreifen und dienen so der genauen Positionierung des Lagerblocks 11 und damit des Verriegelungselements 10 relativ zum Deckblech 4. An den Oberseiten tragen die Positionierpins 20 Markierungen, z. B. Richtungspfeile, welche dem Benutzer angeben, in welche Richtung die Betätigungsschraube 15 gedreht werden muss, um zu verriegeln bzw. zu entriegeln.

Die Montagefläche 16 weist weiter eine Bohrung 21 auf, durch die die Betätigungsschraube 15 hindurchragt. Die Drehachse der Betätigungsschraube 15 erstreckt sich senkrecht zur Montagefläche 16. Die Bohrung 21 ist an der Montagefläche 16 keilförmig eingesenkt, so dass der Kopf 22 der Betätigungsschraube 15 bündig mit der Montagefläche 16 des Lagerblocks 11 abschließt. Wie in Figur 3a zu sehen, ist der Kopf 22 der Betätigungsschraube 15 zwischen dem Lagerblock 11 und dem Deckblech 4 angeordnet. Die Bohrung 21 und damit die Position des Kopfes 22 ist derart gewählt, dass die Drehachse der Betätigungsschraube 15 konzentrisch zu einem Loch 5 im Deckblech 4 ausgerichtet ist. Der Kopf 22 weist einen größeren Durchmesser auf als das zugehörige Loch 5 des Deckblechs 4. An seiner flachen Oberseite ist ein Antrieb in Form eines Innensechsrunds ("Torx") vorgesehen. Folglich kann die Betätigungsschraube 15 von der Außenseite des Deckblechs 4 mittels eines entsprechenden Schraubendrehers durch das korrespondierende Loch 5 im Deckblech 4 hindurch betätigt werden. Da die Befestigungsschrauben 18 einen anderen Antrieb haben, wird zu deren Betätigung ein anderer Schraubendreher benötigt, so dass ein versehentliches Lösen ausgeschlossen ist.

Zur Führung des Schieberiegels 12 weist der Lagerblock 11 einen Führungsvorsprung 23 und an der gegenüberliegenden Seite des Lagerblocks 11 einen L-förmigen Führungsabsatz 24 auf. Am Schieberiegel 12 ist ein Haltebügel 25 vorgesehen, der von dem Führungsvorsprung 23 hintergriffen wird. Der Schieberiegel 12 weist weiter Vorsprünge 26 auf, die den L-förmigen Führungsabsatz 24 hintergreifen. Durch das Zusammenspiel des Führungsvorsprungs 23 und dem Haltebügel 25 einerseits und dem L-förmigen Führungsabsatz 24 und den Vorsprüngen 26 andererseits ist eine Führung des Schieberiegels 12 entlang des Lagerblocks 11 realisiert. Darüber hinaus wird ein Abheben des Schieberiegels 12 von dem Lagerblock 11 in eine von dem Deckblech 4 abgewandte Richtung zwischen der Verriegelungs- und der Freigabeposition des Schieberiegels 12 verhindert. Ein Trennen des Lagerblocks 11 von dem Schieberiegel 12 ist nur bei vollständig ausgeschraubter Betätigungsschraube 15 und ausgebauter Schiebemutter 14 möglich. Zusätzlich müsste der Schieberiegel 12 relativ zu dem Lagerblock 11, von der Verriegelungsposition kommend, über die Freigabeposition hinaus verschoben werden.

Der Schieberiegel 12 weist ein Langloch 27 auf, in dem die Betätigungsschraube 15 sitzt. Die Betätigungsschraube 15 ist in der Bohrung 21 der Montagefläche 16 angeordnet, durchragt das Langloch 27 und ist an ihrem freien Ende mit der Schiebemutter 14 verschraubt. Die Schiebemutter 14 bewegt sich senkrecht zum Deckblech 4. Die Führung der Schiebemutter 14 erfolgt dabei durch Führungsflächen 28 am Lagerblock 11, entlang denen die Schiebemutter 14 auf- und abgleitet. Die Schiebemutter 14 weist an ihrer dem Deckblech 4 abgewandten Seite eine Platte 29 auf, mit der sie auf dem Rand 30 des Langlochs 27 aufliegt, wenn die Betätigungsschraube 15 angezogen ist.

Um nun ein Verschieben des Schieberiegels 12 relativ zu dem Lagerblock 11 zu bewirken, umfasst die Schiebemutter 14 eine erste Keilfläche 31 und eine zweite Keilfläche 32, die in einem schrägen Winkel von ca. 45° zum Deckblech 4 angeordnet sind. Korrespondierend zu den Keilflächen 31, 32 sind am Schieberiegel 12 zwei Gleitflächen 33, 34 ausgebildet.

Diese Gleitflächen 33, 34 sind sowohl zu den Keilflächen 31, 32 wie auch zueinander parallel. Auch die Keilflächen 31, 32, verlaufen zueinander parallel. Sowohl die Keilflächen 31, 32 wie auch die Gleitflächen 33, 34 befinden sich, in Verfahrrichtung des Schieberiegels 12, auf jeweils einander gegenüberliegenden Seiten der Schiebemutter 14 bzw. des Schieberiegels 12. Die Schiebemutter 14 kann mit ihren Keilflächen 31, 32 auf den Gleitflächen 33, 34 des Schieberiegels 12 auf- bzw. abgleiten.

Im Folgenden soll, ausgehend von der Verriegelungsposition, ein Verschieben des Schieberiegels 12 in die Freigabeposition und wieder zurück in die Verriegelungsposition näher erläutert werden.

In der Verriegelungsposition (Fig. 3a) ist die Betätigungsschraube 15 ganz angezogen und die Schiebemutter 14 befindet sich am Lagerblock 11. Der Schieberiegel 12 ist zwischen der Platte 29 der Schiebemutter 14 und dem Lagerblock 11 eingeklemmt und damit arretiert. Die Schiebemutter 14 ist bis auf die Platte 29 vollständig in dem Langloch 27 des Schieberiegels 12 angeordnet. Auf der dem Lagerblock 11 zugewandten Seite der Schiebemutter 14 weist diese Nasen 35 auf, die in Vertiefungen 36 am Lagerblock 11 eingreifen.

Figur 3b zeigt das Verriegelungselement 10 in der Freigabeposition. Die Überführung des Schieberiegels 12 von der Verriegelungs- in die Freigabeposition erfolgt durch Lösen der Betätigungsschraube 15. Da der Durchmesser des Kopfs 22 der Betätigungsschraube 15 größer als das dazugehörige Loch 5 im Deckblech 4 ist, stützt sich der Kopf 22 beim Lösen der Betätigungsschraube 15 am Deckblech 4 ab. Dadurch führt ein Lösen der Betätigungsschraube 15 zu einer Bewegung der Schiebemutter 14 entlang der Drehachse der Betätigungsschraube 15 von dem Lagerblock 11 weg, in Fig. 3b also nach unten. Dabei gleitet die zweite Keilfläche 32 der Schiebemutter 14 auf der zweiten Gleitfläche 34 des Schieberiegels 12 ab. Dies erzwingt eine Bewegung des Schieberiegels 12 parallel zum Lagerblock 11 in Richtung der Freigabeposition.

Der Schieberiegel 12 verfährt parallel zum Lageblock 11, bis ein Anschlag 37 des Schieberiegels 12 an der Betätigungsschraube 15 anschlägt und somit die Verfahrbewegung des Schieberiegels 12 begrenzt. Damit ist die Freigabeposition erreicht; die Schiebemutter 14 drückt über ihre zweite Keilfläche 32 den Schieberiegel 12 gegen den Anschlag 37. Ein Abheben des Schieberiegels 12 von dem Lagerblock 11 wird durch den Führungsvorsprung 23 und den L-förmigen Führungsabsatz 24 verhindert. Da sich der Kopf 22 der Betätigungsschraube 15 gegen das Deckblech 4 abstützt, kann die Betätigungsschraube 15 nicht mehr weiter aus der Schiebemutter 14 ausgeschraubt werden. Somit sind der Schieberiegel 12 und die Schiebemutter 14 in der Freigabeposition arretiert. Deshalb kann auch in der Freigabeposition kein Bauteil des Verriegelungselements 10 ins Innere des Gehäuses 1 fallen

Ein Verschieben des Schieberiegels 12 von der Freigabe- in die Verriegelungsposition erfolgt durch Anziehen der Betätigungsschraube 15. Beim Anziehen der Betätigungsschraube 15 fährt die Schiebemutter 14 entlang der Drehachse der Betätigungsschraube 15 auf den Lagerblock 11 zu, in den Abbildungen also nach oben. Dabei gleitet die erste Keilfläche 31 auf der ersten Gleitfläche 33 ab. Dies bewirkt eine Bewegung des Schieberiegels 12 quer zur Drehachse der Betätigungsschraube 15 in Richtung der Verriegelungsposition. Diese Bewegung wird dadurch begrenzt, dass die Platte 29 bei Erreichen der Verriegelungsposition auf dem Rand 30 des Langlochs 27 und damit auf dem Schieberiegel 12 zur Anlage kommt und diesen, wie oben beschrieben, arretiert.

### Bezugszeichenliste

- 1: Gehäuse
- 2: Seitenwand
- 3: Modulschiene
- 4: Deckblech
- 5: Löcher (im Deckblech)
- 6: erste Abkantung
- 7: zweite Abkantung
- 8: Nut
- 9: Bohrung (im Deckblech zur Befestigung)

- 10: Verriegelungselement
- 11: Lagerblock
- 12: Schieberiegel
- 13: Verriegelungszunge
- 14: Schiebemutter
- 15: Betätigungsschraube

- 16: Montagefläche
- 17: Gewindelöcher (im Lagerblock)
- 18: Befestigungsschrauben
- 19: Senkungen (in der Montagefläche)
- 20: Positionierpins
- 21: Bohrung (in der Montagefläche)
- 22: Kopf (Betätigungsschraube)
- 23: Führungsvorsprung (am Lagerblock)
- 24: L-förmiger Führungsabsatz (am Lagerblock)
- 25: Haltebügel (am Schieberiegel)
- 26: Vorsprung (am Schieberiegel)
- 27: Langloch (im Schieberiegel)
- 28: Führungsflächen (am Lagerblock)
- 29: Platte (an der Schiebemutter)
- 30: Rand (Langloch)
- 31, 32: erste, zweite Keilflächen (an der Schiebemutter)
- 33, 34: erste, zweite Gleitflächen (an dem Schieberiegel)
- 35: Nase (an der Schiebemutter)
- 36: Vertiefung (Lagerblock)
- 37: Anschlag (am Schieberiegel)

## Patentansprüche

1. Verriegelungselement zur Verriegelung eines Deckblechs (4) an einer Modulschiene (3), umfassend
einen Lagerblock (11) mit einer im Wesentlichen ebenen Montagefläche (16) und Befestigungsmitteln zur Montage an der Innenseite des Deckblechs (4),
einen Schieberiegel (12), der auf dem Lagerblock (11) verschieblich gelagert ist und eine Verriegelungszunge (13) aufweist,
ein Schiebegetriebe, das den Schieberiegel (12) von einer Verriegelungsposition, in der die Verriegelungszunge (13) die Modulschiene (3) untergreift, in eine Freigabeposition bzw. umgekehrt verschiebt, mit einem Drehantrieb, der bei montiertem Verriegelungselement (10) durch ein Loch (5) im Deckblech (4) betätigbar ist.

2. Verriegelungselement nach Anspruch 1, **dadurch gekennzeichnet, dass** in der Montagefläche (16) des Lagerblocks (11) Gewindelöcher (17) für Befestigungsschrauben (18) vorgesehen sind.

3. Verriegelungselement nach Anspruch 2, **dadurch gekennzeichnet, dass** die Gewindelöcher (17) Senkungen (19) aufweisen.

4. Verriegelungselement nach einem der Ansprüche 1 bis 3, **dadurch gekennzeichnet,**
**dass** der Drehantrieb eine Betätigungsschraube (15) umfasst, die in dem Lagerblock (11) um eine Drehachse senkrecht zur Montagefläche (16) drehbar gelagert ist und den Schieberiegel (12) durchsetzt;
**dass** eine auf das untere Ende der Betätigungsschraube (15) aufgeschraube Schiebemutter (14) vorgesehen ist, die in den Schieberiegel (12) eingreift;
**dass** am Schieberiegel (12) eine schräge Gleitfläche (33) angeordnet ist, auf der die Schiebemutter (14) derart gleitet, dass ein Anziehen der Betätigungsschraube (15) gegen die Schiebemutter (14) eine Verschiebung des Schieberiegels (12) quer zur Drehachse der Betätigungsschraube (15) bewirkt.

5. Verriegelungselement nach Anspruch 4, **dadurch gekennzeichnet, dass**
die Schiebemutter (14) zwei Keilflächen (31, 32) aufweist, die in einem schrägen Winkel zur Drehachse der Betätigungsschraube (15) verlaufen,
der Schieberiegel (12) zwei korrespondierende Gleitflächen (33, 34) aufweist, die parallel zu den Keilflächen (31, 32) verlaufen und auf denen die Keilflächen (31, 32) gleiten, wodurch beim Anziehen der Betätigungsschraube (15) der Schieberiegel (12) in die eine und beim Lösen der Betätigungsschraube (15) in die entgegengesetzte andere Richtung quer zur Drehachse der Betätigungsschraube (15) gedrückt wird, um den Schieberiegel (12) in die Freigabeposition bzw. Verriegelungsposition zu verschieben.

6. Verriegelungselement nach Anspruch 4 oder 5, **dadurch gekennzeichnet, dass** der Schieberiegel (12) durch die vollständig angezogene Betätigungsschraube (15) in der Verriegelungsposition arretiert ist.

7. Verriegelungselement nach einem der Ansprüche 4 bis 6, **dadurch gekennzeichnet, dass** der Kopf (22) der Betätigungsschraube (15) bündig mit der Montagefläche (16) des Lagerblocks (11) abschließt.

8. Verriegelungselement nach einem der Ansprüche 4 bis 7, **dadurch gekennzeichnet, dass** der Kopf (22) der Betätigungsschraube (15) einen Antrieb für einen Schraubendreher hat.

9. Verriegelungselement nach einem der Ansprüche 4 bis 8, **dadurch gekennzeichnet, dass** an dem Schieberiegel (12) ein Anschlag (37) vorgesehen ist, der gegen die Betätigungsschraube (15) fährt, bevor diese ganz aus der Schiebemutter (14) herausgedreht ist.

10. Verriegelungselement nach einem der Ansprüche 4 bis 9, **dadurch gekennzeichnet, dass** die Betätigungsschraube (15) in einem Langloch (27) des Schieberiegels (12) sitzt.

11. Gehäuse zur Aufnahme elektronischer Komponenten, umfassend
vordere und hintere Modulschienen (3),
wenigstens ein Deckblech (4) mit im Raster angeordnete Löcher (5) und mit einer Abkantung (6), die in eine Nut (8) einer Modulschiene (3) eingreift,
**dadurch gekennzeichnet, dass**
an der Innenseite des Deckblechs (4) wenigstens ein Verriegelungselement (10) nach einem der Ansprüche 1 bis 10 derart befestigt ist, dass die Verriegelungszunge (13) in Verriegelungsposition die Modulschiene (3) untergreift.

12. Gehäuse nach Anspruch 11 mit einem Verriegelungselement nach Anspruch 2, **dadurch gekennzeichnet, dass** die Gewindelöcher (17) in der Montagefläche (16) des Lagerblocks (11) entsprechend dem Raster der Löcher (5) im Deckblech (4) angeordnet sind.

13. Gehäuse nach Anspruch 12 mit einem Verriegelungselement nach Anspruch 3, **dadurch gekennzeichnet, dass** die Drehachse der Betätigungsschraube (15) konzentrisch zu einem Loch (5) des Deckblechs (4) ist.

14. Gehäuse nach Anspruch 13, **dadurch gekennzeichnet, dass** der Kopf (22) der Betätigungsschraube (15) einen größeren Durchmesser hat als das korrespondierende Loch (5) im Deckblech (4).

15. Gehäuse nach einem der Ansprüche 12 bis 14, **dadurch gekennzeichnet, dass** an der Montagefläche (16) des Lagerblocks (11) Positionierpins (20) ausgebildet sind, welche in Löcher (5) des Deckblechs (4) eingreifen.

## Claims

1. A locking element for locking of a panel cover (4) on a module rail (3), the locking element (10) comprising:
a bearing block (11) with an essentially plane mounting surface (16) and having fasteners for mounting on the inside of the panel cover (4);
a slide lock (12) movably mounted on the bearing block (11) and having a locking tab (13); and
a slide mechanism configured to transfer the slide lock (12) from a locked position in which the locking tab (13) engages beneath the module rail (3) to a release position, and vice versa, comprising a rotary actuator which is actuable in the installed locking element (10) through a hole (5) in the panel cover (4).

2. The locking element of claim 1, further comprising threaded holes (17) disposed in the mounting surface (16) of the bearing block (11) adapted to receive fastening screws (18).

3. The locking element of claim 2, wherein the threaded holes (17) have countersinks (19).

4. The locking element in accordance with one of claims 1 to 3, wherein
the rotary actuator includes an actuating screw (15) configured to rotate in the bearing block (11) around a rotational axis perpendicular to the mounting surface (16), the actuating screw (15) passing through the slide lock (12);
a slide nut (14) is screwed onto the lower end of the actuating screw (15) and engages in the slide lock (12);
an oblique sliding surface (33) is arranged on the slide lock (12), on which the slide nut (14) slides so that tightening of the actuating screw (15) relative to slide nut (14) produces movement of the slide lock (12) transverse to the rotational axis of actuating screw (15).

5. The locking element of claim 4, wherein
the slide nut (14) has two wedge surfaces (31, 32) oriented at an oblique angle to the rotational axis of the actuating screw (15);
the slide lock (12) has two corresponding sliding surfaces (33, 34) which extend parallel to the wedge surfaces (31, 32) and on which the wedge surfaces (31, 32) slide so that during tightening of the actuating screw (15) the slide lock (12) is forced in one direction and during loosening of the actuating screw (15) the slide lock (12) is forced in the opposite direction transverse to the rotational axis of actuating screw (15) in order to transfer the slide lock (12) into the release position respectively into the locked position.

6. The locking element in accordance with one of claims 4 or 5, wherein the slide lock (12) is locked by the completely tightened actuating screw (15) in the locked position.

7. The locking element in accordance with one of claims 4 to 6, wherein the head (22) oft the actuating screw (15) is closed off flush with the mounting surface (16) of the bearing block (11).

8. The locking element in accordance with one of claims 4 to 7, wherein the head (22) of the actuating screw (15) has an actuator for a screwdriver.

9. The locking element in accordance with one of claims 4 to 8, further comprising a stop (37) on the slide lock (12), the stop (37) traveling against the actuating screw (15) before it is loosened entirely from the slide nut (14).

10. The locking element in accordance with one of claims 4 to 9, wherein the actuating screw (15) sits in an elongated hole (27) of the slide lock (12).

11. A housing to accommodate electronic components, comprising:
front and rear module rails (3);
at least one panel cover (4) with holes (5) arranged in a grid pattern and having a flanging (6) which engages in a groove (8) of a module rail (3);
**characterized in, that**
at least one locking element (10) in accordance with one of claims 1 to 10 is fastened on the inside of the panel cover (4) so that the locking tab (13) engages beneath the module rail (3) in the locked position.

12. The housing of claim 11 with a locking element according to claim 2, wherein the threaded holes (17) are arranged in the mounting surface (16) of the bearing block (11) according to the hole pattern in the panel cover (4).

13. The housing of claim 12 with a locking element according to claim 3, wherein the rotational axis of the actuating screw (15) is concentric to a hole (5) of the panel cover (4).

14. The housing of claim 13, wherein the head (22) of the actuating screw (15) has a larger diameter than the corresponding hole (5) in the panel cover (4).

15. The housing in accordance with one of claims 12 to 14, further comprising positioning pins (20) formed on the mounting surface (16) of the bearing block (11), the positioning pins (20) engaging in the holes (5) of the panel cover (4).

## Revendications

1. Élément de verrouillage destiné au verrouillage d'un capot (4) sur un rail de module (3), comprenant
un bloc support (11) avec une surface de montage (16) essentiellement plane et des moyens de fixation destinés au montage sur le côté intérieur du capot (4),
un verrou coulissant (12), qui est monté coulissante sur le bloc support (11) et présente une lame de verrouillage (13),
un mécanisme coulissant, qui fait coulisser le verrou coulissant (12) d'une position de verrouillage, dans laquelle la lame de verrouillage (13) enserre le rail de module (3), vers une position de libération ou inversement, une commande de rotation qui peut être actionnée à travers un trou (5) présent dans le capot (4) lorsque l'élément de verrouillage (10) est monté.

2. Élément de verrouillage selon la revendication 1, **caractérisé en ce que** des trous filetés (17) destinés à des vis de fixation (18) sont prévus dans la surface de montage (16) du bloc support (11).

3. Élément de verrouillage selon la revendication 2, **caractérisé en ce que** les trous filetés (17) présentent des chanfreins (19).

4. Élément de verrouillage selon l'une quelconque des revendications 1 à 3, **caractérisé en ce que**,
la commande de rotation comporte une vis d'actionnement (15), qui est montée rotative dans le bloc support (11) autour d'un axe de rotation perpendiculairement à la surface de montage (16) et traverse le verrou coulissant (12) ;
un écrou coulissant (14) vissé sur l'extrémité inférieure de la vis d'actionnement (15) est prévu, qui engrène dans le verrou coulissant (12) ;
sur le verrou coulissant (12) est agencée une glissière (33) oblique sur laquelle l'écrou coulissant (14) glisse de telle manière qu'un serrage de la vis d'actionnement (15) contre l'écrou coulissant (14) provoque un coulissement du verrou coulissant (12) perpendiculairement à l'axe de rotation de la vis d'actionnement (15).

5. Élément de verrouillage selon la revendication 4, **caractérisé en ce que**
l'écrou coulissant (14) présente deux surfaces en forme de coin (31, 32), qui passent selon un angle oblique par rapport à l'axe de rotation de la vis d'actionnement (15),
le verrou coulissant (12) présente deux glissières (33, 34) correspondantes, qui passent parallèlement aux surfaces en forme de coin (31, 32) et sur lesquelles glissent les surfaces en forme de coin (31, 32), grâce à quoi, lors du serrage de la vis d'actionnement (15), le verrou coulissant (12) est tiré dans une direction et, lors du desserrage de la vis d'actionnement (15), le verrou coulissant (12) est tiré dans l'autre direction, opposée, perpendiculairement à l'axe de rotation de la vis d'actionnement, afin de faire coulisser le verrou coulissant (12) dans la position de libération ou bien dans la position de verrouillage.

6. Élément de verrouillage selon la revendication 4 ou 5, **caractérisé en ce que** le verrou coulissant (12) est bloqué dans la position de verrouillage grâce à la vis d'actionnement (15) complètement serrée.

7. Élément de verrouillage selon l'une quelconque des revendications 4 à 6, **caractérisé en ce que** la tête (22) de la vis d'actionnement (15) se trouve au ras de la surface de montage (16) du bloc support (11).

8. Élément de verrouillage selon l'une quelconque des revendications 4 à 7, **caractérisé en ce que** la tête (22) de la vis d'actionnement (15) présente un moyen d'entraînement pour un tournevis.

9. Élément de verrouillage selon l'une quelconque des revendications 4 à 8, **caractérisé en ce qu'**une butée (37) est prévue sur le verrou coulissant (12), qui vient contre la vis d'actionnement (15) avant que celle-ci ne soit complètement sortie de l'écrou coulissant (14).

10. Élément de verrouillage selon l'une quelconque des revendications 4 à 9, **caractérisé en ce que** la vis d'actionnement (15) se trouve dans un trou allongé (27) du verrou coulissant (12).

11. Boîtier destiné à accueillir des composants électroniques, comprenant
des rails de module (3) avant et arrière,
au moins un capot (4) avec des trous (5) agencés selon une trame et avec un rabattement (6), qui vient en prise dans une rainure (8) d'un rail de module (3),
**caractérisé en ce que**
sur le côté intérieur du capot (4) est fixé au moins un élément de verrouillage (10) selon l'une quelconque des revendications 1 à 10, de telle manière que, en position de verrouillage, la lame de verrouillage (13) enserre le rail de module (3).

12. Boîtier selon la revendication 11, avec un élément de verrouillage selon la revendication 2, **caractérisé en ce que** les trous filetés (17) de la surface de montage (16) du bloc support (11) sont agencés dans le capot (4) en fonction de la trame des trous (5).

13. Boîtier selon la revendication 12, avec un élément de verrouillage selon la revendication 3, **caractérisé en ce que** l'axe de rotation de la vis d'actionnement (15) est concentrique par rapport à un trou (5) du capot (4).

14. Boîtier selon la revendication 13, **caractérisé en ce que** la tête (22) de la vis d'actionnement (15) présente un diamètre supérieur à celui du trou correspondant (5) du capot (4).

15. Boîtier selon l'une quelconque des revendications 12 à 14, **caractérisé en ce que** des broches de positionnement (20) sont réalisées sur la surface de montage (16) du bloc support (11), qui viennent en prise dans des trous (5) du capot (4).
